# EUROPEAN PATENT SPECIFICATION

(11) **EP 0 607 474 B1**
(45) Date of publication and mention of the grant of the patent: **06.06.2001**
(21) Application number: 93100392.5
(22) Date of filing: 12.01.1993
(51) Int. Cl.: H01L 27/02

(54) **Semiconductor integrated circuit with layer for isolating elements in substrate**
Integrierte Halbleiterschaltung mit einer Schicht zur Isolation der einzelnen Elemente auf einem Substrat
Circuit intégré semi-conducteur avec une couche pour l'isolation d'éléments dans un substrat

(43) Date of publication of application: 27.07.1994
(73) Proprietor: MITSUBISHI DENKI KABUSHIKI KAISHA, Tokyo 100 (JP)
(72) Inventor: Fujii, Nobuo, Yokohama-shi, Kanagawa 227 (JP); Mizukawa, Yosuke, c/o Mitsubishi Denki Eng. K.K., Nagaokakyo-shi, Kyoto 617 (JP); Mitsuhashi, Yasuo, c/o Mitsubishi Denki Eng. K.K., Nagaokakyo-shi, Kyoto 617 (JP)
(74) Representative: Pfenning, Meinig & Partner

(56) References cited:
- EP-A- 0 449 093
- US-A- 5 051 612
- PATENT ABSTRACTS OF JAPAN vol. 14, no. 18 (E-873) 16 JANUARY 1990 & JP-A-01 261 856 ( HITACHI ) 18 OCTOBER 1989

## Description

### BACKGROUND OF THE INVENTION

### 1. Field of the Invention:

This invention relates to a semiconductor integrated circuit (hereinafter also called "IC"), and more particularly to a concept of reducing the possibility of a parasitic diode in an IC having an element isolating structure.

### 2. Description of the Related Art:

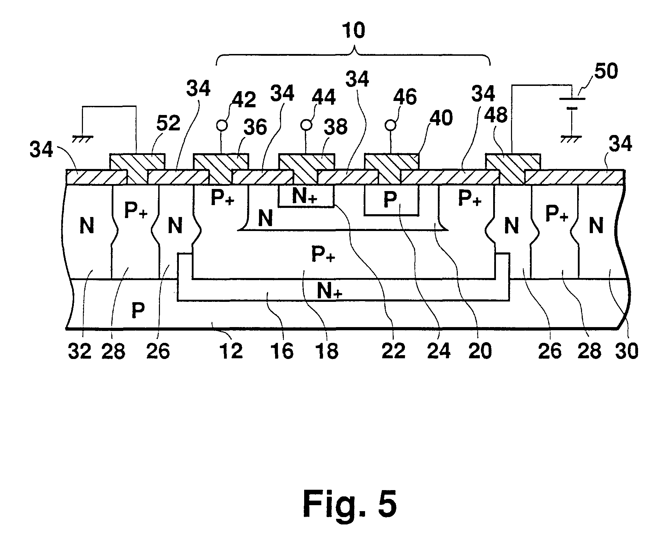

FIG. 5 of the accompanying drawings is a cross-sectional view showing a typical IC. The IC has a PNP bipolar transistor 10 formed in a P substrate 12.

In the P substrate 12, an N⁺ implanted layer 16 is formed by, for example, ion implantation. Formed over the N⁺ implanted layer 16 is a P⁺ layer 18 on which an N epitaxial layer 20 is formed. An N⁺ layer 22 and a P layer 24 are formed in the N epitaxial layer 20. The PNP transistor 10 consists of the P⁺ layer 18, the N epitaxial layer 20 and the P layer 24 as the collector layer, base layer and emitter layer, respectively. The N⁺ layer 22 is the base contact layer of the PNP transistor 10.

The PNP transistor 10, around which an N epitaxial layer 26 is formed, is contiguous to other elements ( such as transistors and diodes) via a diffusion layer 28. Only parts (N epitaxial layers 30 and 32) of the other elements contiguous to the PNP transistor 10 are illustrated in FIG. 5. The diffusion layer 28 is a so-called element-isolating layer for electrically isolating the PNP transistor 10 from the other elements horizontally in FIG. 5 and may be extensively used in circuit-isolation.

In the manufacture of the IC of FIG. 5, the foregoing layers 16 through 32 are formed in the P substrate 12, and then an insulating film 34 is formed in a predetermined pattern on the surface of the P substrate 12. If silicon is used as the substance of the P substrate 12, the insulating film 34 is usually formed by a surface oxidation process. The insulating film 34 to be obtained by the surface oxidation process is a silicon oxide film. Upon forming the silicon oxide film 34, a conductive layer is formed in a predetermined pattern on the top surface of the P substrate 12. The substance of the conductive layer is usually metal.

Part of the conductive layer pattern is used as a collector electrode 36, a base electrode 38 or an emitter electrode 40 of the PNP transistor 10. The collector electrode 36, the base electrode 38 and the emitter electrode 40 are formed respectively on the collector layer 18, the base layer 20 via the base contact layer 22, and the emitter layer 24. A collector terminal 42, a base terminal 44 and an emitter terminal 46 are connected to the collector electrode 36, the base electrode 38 and emitter electrode 40, respectively.

Part of the conductive layer pattern is used in applying a supply voltage to the N epitaxial layer 26 and connecting the element-isolating layer 28 to ground; that is, a positive d.c. voltage from a battery 50 is applied to the conductive layer 48 formed on the N epitaxial layer 26, and on the other hand, a conductive layer 52 formed on the element-isolating layer 28 is grounded. Therefore the junction between the N epitaxial layer 26 and the element-isolating layer 28 is reverse biased. The N⁺ implanted layer 16 has the same potential as that of the conductive layer 52; therefore the junction between the N+ implanted layer 16 and the P substrate 12 is reverse biased. As a result, a current will stop flowing through these PN junctions; that is, as the result that these PNP junctions become insulate, the PNP transistor 10 will be electrically isolated from the elements contiguous to it. Usually a positive d.c. voltage is also applied to the N epitaxial layer 30, 32. In the case of a double-power-source-driven IC, the reverse biasing may be performed by either the positive power source or the negative power source.

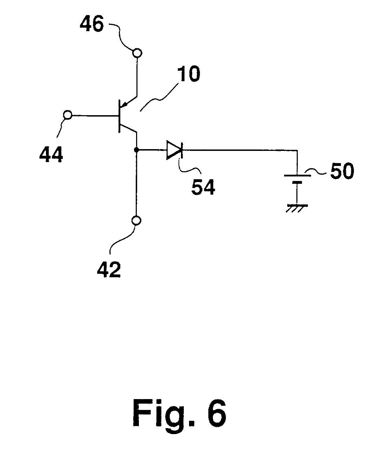

Thus the N layer 26 around the PNP transistor 10 is essential to element isolation using the element-isolating layer 28, but the junction between the N epitaxial layer 26 and the collector layer 18 functions as a parasitic diode. FIG. 6 shows a parasitic diode 54 formed by this junction. As shown in FIG. 6, the junction between the N epitaxial layer 26 and the collector layer 18 forms a PN diode (i.e., the parasitic diode 54) connected to the collector of the PNP transistor 10. The parasitic diode 54 functions as an electrostatic capacity between the collector of the PNP transistor 10 and the battery 50. This electrostatic capacity would generally affect the frequency characteristic of the circuit. In fact the junction between the N epitaxial layer 26 and the element-isolating layer 28 also functions as a parasitic diode, but this diode does not contribute to circuit operation; therefore this diode is omitted in FIG. 6 and the following description. "The diode does not contribute to" means that it does not appear on an equivalent circuit showing the connections between the individual elements formed in the P substrate 12.

EP-A-0 449 093 discloses a circuital arrangement for preventing latch-up phenomena in vertical pnp transistors with insulated collector which includes a semiconductor element around which a pn junction is formed. Means for reverse biasing the pn junction are provided and a voltage is applied to the parasitic diode which is controlled according to the switching state of the isolated semiconductor element in such a manner that the breakdown voltage of the semiconductor element is not limited due to the breakdown of the parasitic diode. For this reason, an auxiliary transistor is provided which opens when the semiconductor element is in the off state, thereby limiting the reverse voltage applied to the parasitic diode.

In US-A-5,051,612, a method for preventing forward biasing of pn junctions in junction isolated devices to prevent parasitic transistor action is disclosed including a biasing element which is connected to the substrate/isolation regions to switch the regions to a low potential.

It is an object of this invention to provide a semiconductor integrated circuit which can realize isolation between elements or circuits, without forming a parasitic diode affective to the frequency characteristic of the circuit.

The object is solved by the features of claim 1.

With the inventive arrangement, the PN junction between the first and second layers is reverse biased and a current flowing through the junction is cutoff. Then, the isolation object element is isolated from other elements. With these arrangements, at least part of the isolation object element is connected to the first layer in a PN junction. The potential change at this part is detected for adjusting the potential of the first layer; that is, when the potential change at the junction is detected, the potential of the first layer is adjusted so as to cancel the detected potential change, thus keeping a constant voltage to be applied to the PN junction between the part and the first layer. Meanwhile the PN junction between the part and the first layer functions as the parasitic diode connected to the isolation object element. Given that the voltage to be applied to the PN junction between the part and the first layer is kept at a constant value, the voltage to be applied to opposite ends of the parasitic diode will become constant. If this voltage is lower than a threshold of the parasitic diode in the reverse direction, the parasitic diode assumes a cutoff status all the time so that its junction capacity will not affect the frequency characteristic of the circuit.

This invention may be realized in various kinds of embodiments. For example, the PN junction in connection with the isolation of elements may be reverse biased by a d.c. power source such as a battery. At that time, for keeping the parasitic diode permanently in a cutoff state, the potential to be applied to the parasitic diode from the d.c. power source should be varied in common mode with the detected potential of the first layer. The methods of varying the potential to be applied to the parasitic diode from the d.c. power source can be divided chiefly into the following two: shifting the potential to be outputted from the d.c. power source; and dropping the potential to be outputted from the d.c. power source by any means.

The former method may be realized by a circuit structure, for example, in which the potential at one terminal, out of the two terminals of the d.c. power source, opposite to the terminal to be connected with the d.c. power source and the first layer is kept floating, whereupon this floating potential is varied in common mode with the detected potential change. In this case detection of a potential change can be performed by a voltage follower whose gain is +1.

The latter method may be realized by a circuit structure, for example, in which a resistor is inserted between the d.c. power source and the first layer, and a voltage drop is caused to occur at the resistor. In this case a current to flow in the resistor must have such a value as to vary in common mode with the value of the detected potential change. The means for varying a current, which is to flow into the resistor, in conformity with the value of the detected potential change is exemplified by an element, such as a transistor, which can adjust the output current value responsive to the input potential.

The individual layers constituting the IC of this invention may be formed by the conventional process. For example, the first layer may be formed as an epitaxial layer. The IC may include an implanted layer for isolating the isolation object element from the semiconductor substrate. Further the isolation object element may be a transistor, a diode, a capacitor, etc.

The semiconductor substrate may be either a P substrate or an N substrate. If the semiconductor substrate is a P substrate, the first layer should be an N layer, the second layer a P layer, and the part of the isolation object element to be connected to the first layer as a PN junction is a P layer; the reverse biasing means applies to the first layer a potential lower than the potential at the second layer.

### BRIEF DESCRIPTION OF THE DRAWINGS

FIG. 1 is a circuit diagram showing a circuit structure according to a first embodiment of this invention;
FIG. 2 is a circuit diagram showing a circuit structure according to a second embodiment;
FIG. 3 is a circuit diagram showing a circuit structure according to a third embodiment;
FIG. 4 is a circuit diagram showing a circuit structure according to a fourth embodiment;
FIG. 5 is a cross-sectional diagram showing a PNP transistor which is electrically isolated from adjacent elements by reverse biasing the PN junctions around the PNP transistor; and
FIG. 6 is a circuit diagram showing a circuit structure in which an N layer connected to an element-isolating P layer forms a parasitic diode between the element-isolating P layer and a collector layer.

### DETAILED DESCRIPTION

Various preferred embodiments of this invention will now be described with reference to the accompanying drawings. Each embodiment is generally similar in element structure and element-isolating structure to the semiconductor integrated circuit of FIG. 5, having a parasitic diode in the form as shown in FIG. 6. In the following description, like reference numerals designate parts or elements similar to those of FIGS. 5 and 6, and equivalent circuit diagrams are used for convenience of comparison with FIG. 6. Repetition of the description in connection with FIGS. 5 and 6 is omitted here for clarity.

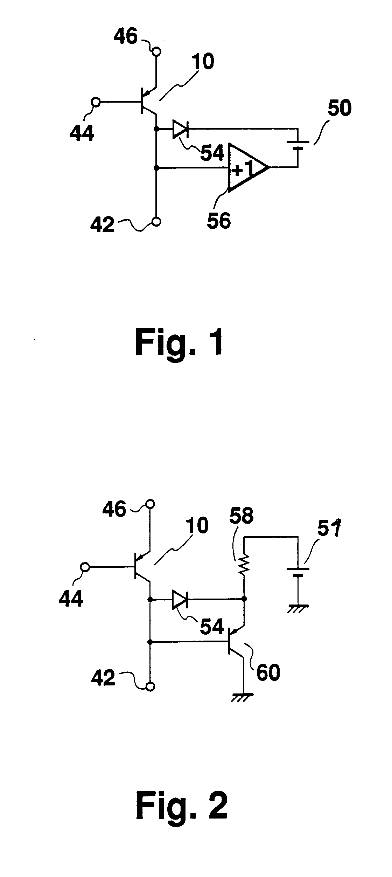

FIG. 1 shows a partial semiconductor integrated circuit according to a first embodiment of this invention. In this embodiment a battery 50 is used differently from FIG. 5. The battery 50 applies a voltage between the conductive layers 48, 52 to reversely biasing the junction between the element-isolating layer 28 and the N epitaxial layer 26. Like FIG. 5, the potential of the P substrate 12 and the potential of the conductive layer 52 are also grounded.

In this embodiment, one end of the battery 50 is floating from the grounded potential, unlike FIG. 6, and is connected to the collector terminal 42 via the voltage follower 56. The voltage follower 56 is a d.c. amplifier whose gain is +1, and which has a function of detecting the potential of the collector terminal 42 and varying the potential at the one end of the battery 50.

More specifically, the collector potential of the PNP transistor 10 is detected by the voltage follower 56. Since the gain of the voltage follower 56 is +1, the output potential of the voltage follower will vary in response to the potential change of the collector of the PNP transistor 10. The output terminal of the voltage follower 56 is connected to the one end of the battery 50. In this embodiment, since the connecting point between the voltage follower 56 and the battery 50 is a negative terminal of the battery 50, the potential at a positive terminal of the battery 50 varies in common mode with the collector potential of the PNP transistor 10. "Common mode" means a state in which when the collector potential of the PNP transistor 10 rises, the potential at the positive terminal of the battery 50 will rise similarly, and when the collector potential of the PNP transistor 10 is lowered, the potential at of the positive terminal of the battery 50 will be lowered similarly.

The positive terminal of the battery 50 is connected to the N epitaxial layer 26 via the conductive layer 48 as shown in FIG. 5 so that the potential at the positive terminal of the battery 50 will be applied to the N epitaxial layer 26. Since the N expitaxial layer 26 is a cathode of the parasitic diode 54 resulting from the junction between the N epitaxial layer 26 and the collector layer 18, the voltage to be applied to the parasitic diode 54 will be a potential difference between the collector of the PNP transistor 10 and the positive terminal of the battery 50.

The potential at the positive terminal of the battery 50 varies in common mode with the collector potential of the PNP transistor 10 so that the voltage to be applied to the parasitic diode 54 will be constant. If this voltage is lower than a reverse threshold voltage of the parasitic diode 54, the parasitic diode 54 will be permanently in a cutoff state so that no current will flow through the parasitic diode 54. In this status, the parasitic diode 54 will not affect the circuit operation at all and hence the frequency characteristic of the circuit is also unaffected.

Thus according to this embodiment, since the collector potential of the PNP transistor 10 is detected to vary the cathode potential of the parasitic diode 54 in common mode with the detected collector potential, it is possible to keep the voltage, which is to be applied to the parasitic diode 54, at a constant value. Assuming that the voltage to be applied to the parasitic diode 54 is lower than a threshold voltage, it is possible to keep the parasitic diode 54 in a cutoff state, thus guaranteeing the frequency characteristic of the circuit as designed.

FIG. 2 shows a partial semiconductor integrated circuit according to a second embodiment. In this embodiment, the potential at the negative terminal of the battery 51 is not floating but is fixed to the ground. The positive-terminal of the battery 51 is connected to the conductive layer 48 via a resistor 58 so that the potential of the cathode (N epitaxial layer 26) of the parasitic diode 54 will correspond to a dropped potential across the resistor 58 from the potential of the positive terminal of battery 51. The resistor 58 may be either a diffusion resistor obtained by diffusing impurities into the P substrate 12 or a resistor formed from polycrystalline silicon.

In this embodiment, another PNP transistor 60 is used in addition to the PNP transistor 10. The PNP transistor 60 may be either formed, likewise the PNP transistor 10, in the P substrate 12 or formed as a parasitic transistor in the P substrate 12.

The base of the PNP transistor 60 is connected to the collector of the PNP transistor 10. Since the collector of the PNP transistor 10 has the conductive layer 42 as an electrode, this connection is realized as the connection between the conductive layer 42 and the base electrode of the PNP transistor 60. The base electrode of the PNP transistor 60 may be formed in the same method as the base electrode 44 of the PNP transistor 10. The emitter of the PNP transistor 60 is connected to one end of the resistor 58. Specifically, the emitter electrode of the PNP transistor 60 is connected to the conductive layer 48 and may be formed in the same method as the emitter electrode 46 of the PNP transistor 10. Further the collector of the PNP transistor 60 is grounded; specifically the collector electrode of the PNP transistor 60 is connected to the conductor layer 52 and may be formed in the same method as the collector electrode 42 of the PNP transistor 52.

This embodiment can give the same results as the first embodiment. For example, when the collector potential of the PNP transistor 10 is lowered, the current flowing between the emitter and collector of the PNP transistor 60 is increased. The voltage drop due to the resistor 58 will thereby be increased so that the cathode potential of the parasitic diode 54 will be lowered by the amount of the voltage drop due to the resistor 58. Therefore the voltage to be applied to the opposite ends of the parasitic diode 54 will not vary, irrespective of the lowering of the collector potential of the PNP transistor 10.

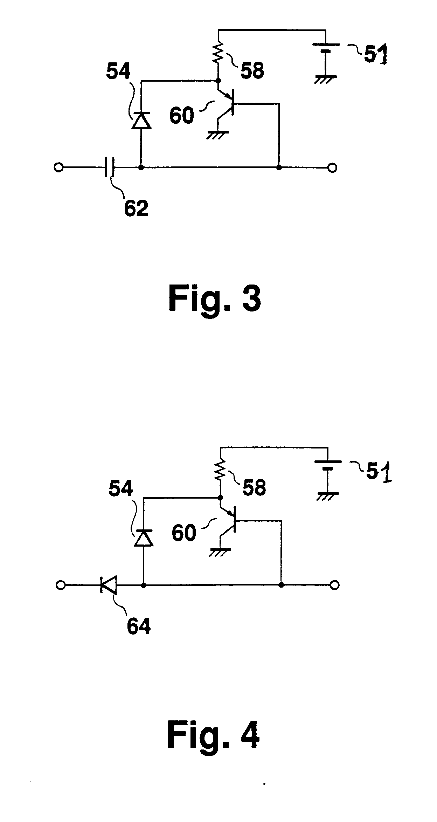

FIG. 3 shows a partial semiconductor integrated circuit according to a third embodiment. In this embodiment, the object element to be isolated from adjacent elements is a capacitor 62 rather than the PNP transistor 10. For forming the capacitor 62, an element-isolating structure is formed in the same method as the case shown in FIG. 5, and then a dielectric layer is formed on the surface of the element-isolating structure by the known method such as surface nitrization. One electrode of the capacitor 62 is a P layer, and the epitaxial layer to which the positive potential from the battery 51 is to be applied makes a PN junction with this P layer. Therefore as represented in an equivalent circuit, the parasitic diode 54 will be formed between the one electrode of the capacitor 62 and the positive terminal of the battery 51. This invention can be adopted also in this case if an emitter follower having the PNP transistor 60 and the resistor 58 is provided between the parasitic diode 54 and the battery 51, likewise in the second embodiment.

FIG. 4 shows a partial semiconductor integrated circuit according to a fourth embodiment. In this embodiment, the object element to be isolated from adjacent elements is a diode 64 rather than the PNP transistor 10. The anode of the diode 64 is a P layer, and the epitaxial layer to which the positive potential from the battery 51 is to be applied makes a PN junction with this P layer. Therefore as represented in an equivalent circuit, a parasitic diode 54 is formed between the anode of the diode 64 and the positive terminal of the battery 51. This invention can be adopted also in this case if an emitter follower having the PNP transistor 60 and the resistor 58 is provided between the parasitic diode 54 and the battery 51, likewise in the second embodiment.

The object element to be isolated may be an NPN transistor.

As mentioned above, according to this invention, since the voltage to be applied to the parasitic diode is kept constant so that the parasitic diode will assume a cutoff state permanently, it is possible to prevent the diode from affecting the frequency characteristic of the circuit.

## Claims

1. Electronic circuit comprising;
a semiconductor element (10, 62, 64) around which a PN junction is formed in a semiconductor substrate;
means (50) for reverse biasing the PN junction around said semiconductor element (10, 62, 64) to isolate said semiconductor element from other elements;
and
means (56, 58, 60) for keeping a parasitic diode (54), which is adapted to be located between a first layer (26) around said semiconductor element (10, 62, 64), thereby constituting a PN junction and a second layer (18) constituting said semiconductor element (10), permanently in cutoff state,
a third layer (28) arranged so as to be connected to said first layer (26) to form a PN junction;
**characterized** by
said means (50, 51) for reverse biasing being effective on the PN junction of said first and third layers (26, 28);
means (56, 60) for detecting a potential change at the PN junction between said semiconductor element (10, 62, 64) and said first layer (26); and
means (56, 58, 60) for adjusting the potential of said first layer (26) so as to cancel said detected potential change;
said means (56, 60) for detecting a potential change and said means (56, 58,60) for adjusting the potential being connected to the parasitic diode (54) and forming said cutoff state keeping means (56, 58, 60) being operable to keep a voltage, which is applied across said parasitic diode (54), at constant value less than a threshold of said parasitic diode (54).

2. Electronic circuit according to claim 1,
characterized by a semiconductor substrate (12), said semiconductor element (10, 62, 64) being formed in said semiconductor substrate (12) and adapted to be isolated from other elements formed in said semiconductor substrate (12); and said first layer (26) and third layer (28) also being formed in said semiconductor substrate (12).

3. Electronic circuit according to claim 1 or 2,
characterized in that said reverse biasing means is a dc power source (50) connected at one end to said first layer (26), said potential adjusting means (56) being operable for increasing or decreasing the potential at the other end of said dc power source (50) with an increase or decrease of said detected potential change.

4. Electronic circuit according to claim 3,
characterizing in that said potential change detecting means includes a voltage follower (56) with a gain of +1 connected to the PN junction of said semiconductor element (10, 62, 64) with said first layer (26).

5. Electronic circuit according to claim 1 or 2,
characterized in that said reverse biasing means is a dc power source (51) connected between said first and third layers (26, 28), said potential adjusting means is a resistor (58) located between said dc power source (51) and said first layer (26) for causing a voltage drop according to the detected potential change.

6. Electronic circuit according to claim 5,
characterized in that said potential change detecting means includes an element (60) whose output current may vary according to the potential at the junction of said semiconductor element (10, 62, 64) and said first layer (26).

7. Electronic circuit according to any of claims 1 to 6,
characterized in that said first layer (26) is an epitaxial layer formed in said semiconductor substrate (12).

8. Electronic circuit according to any of claims 1 to 7,
characterized by an implanted layer (16) for isolating said semiconductor element (10, 62, 64) from said semiconductor substrate (12).

9. Electronic circuit according to any of claims 1 to 8,
characterized in that said semiconductor element is any of a transistor (10), a diode (62) and a capacitor (64).

10. Electronic circuit according to any of claims 1 to 9,
characterized in that said semiconductor substrate (12) is a P substrate, said first layer (26) is an N layer, said third layer (28) is a P layer, a PN junction is formed between a P layer of said semiconductor element (10, 62, 64) and said first layer (26), and said reverse biasing means (50, 51) being operable to apply to said first layer (26) a lower potential than that applied to said third layer (28).

## Patentansprüche

1. Elektronische Schaltung, welche aufweist:
ein Halbleiterelement (10, 62, 64), um welches ein PN-Übergang in einem Halbleitersubstrat gebildet ist;
Mittel (50) zum Vorspannen des PN-Übergangs in Sperrrichtung um das Halbleiterelement (10, 62, 64), um das Halbleiterelement gegenüber anderen Elementen zu isolieren;
und
Mittel (56, 58, 60) zum Beibehalten einer parasitären Diode (54), welche sich zwischen einer ersten Schicht (26) um das Halbleiterelement (10, 62, 64), wodurch ein PN-Übergang gebildet ist, und einer zweiten Schicht (18), die das Halbleiterelement (10) bildet, ständig in einem Sperrzustand befindet, und
eine dritte Schicht (28), welche so angeordnet ist, daß sie mit der ersten Schicht (26) verbunden ist, um einen PN-Übergang zu bilden;
**dadurch gekennzeichnet**, daß die Mittel (50, 51) zum Vorspannen in Sperrrichtung auf den PN-Übergang der ersten und der dritten Schicht (26, 28) wirksam sind;
Mittel (56, 60) zum Erfassen einer Potentialänderung an dem PN-Übergang zwischen dem Halbleiterelement (10, 62, 64) und der ersten Schicht (26) vorgesehen sind; und
Mittel (56, 58, 60) zum Einstellen des Potentials der ersten Schicht (26) in der Weise vorgesehen sind, daß die erfaßte Potentialänderung aufgehoben wird;
wobei die Mittel (56, 60) zum Erfassen einer Potentialänderung und die Mittel (56, 58, 60) zum Einstellen des Potentials
mit der parasitären Diode (54) verbunden sind und die Mittel (56, 58, 60) zum Beibehalten des Sperrzustandes bilden, die betätigbar sind, um eine Spannung, welche über die parasitäre Diode (54) angelegt ist, auf einem konstanten Wert zu halten, der niedriger ist als ein Schwellenwert der parasitären Diode (54).

2. Elektronische Schaltung nach Anspruch 1, gekennzeichnet durch ein Halbleitersubstrat (12), wobei das Halbleiterelement (10, 62, 64) in dem Halbleitersubstrat (12) gebildet ist und gegenüber anderen in dem Halbleitersubstrat (12) gebildeten Elementen isoliert ist; und wobei die erste Schicht (26) und die dritte Schicht (28) auch in dem Halbleitersubstrat (12) gebildet sind.

3. Elektronische Schaltung nach Anspruch 1 oder 2, dadurch gekennzeichnet, daß die Mittel zum Vorspannen in Sperrrichtung eine Gleichspannungsquelle (50) sind, die an einem Ende mit der ersten Schicht (26) verbunden ist, und daß die Mittel (56) zum Einstellen des Potentials betätigbar sind zum Erhöhen oder Herabsetzen des Potentials an dem anderen Ende der Gleichspannungsquelle (50) bei einer Erhöhung oder Herabsetzung der erfaßten Potentialänderung.

4. Elektronische Schaltung nach Anspruch 3, dadurch gekennzeichnet, daß die Mittel zum Erfassen der Potentialänderung einen Spannungsfolger (56) mit einer Verstärkung +1 enthalten, der mit dem PN-Übergang des Halbleiterelements (10, 62, 64) mit der ersten Schicht (26) verbunden ist.

5. Elektronische Schaltung nach Anspruch 1 oder 2, dadurch gekennzeichnet, daß die Mittel zum Vorspannen in Sperrrichtung eine Gleichspannungsquelle (51) sind, die zwischen die erste und die dritte Schicht (26, 28) geschaltet ist, und daß die Mittel zum Einstellen des Potentials ein Widerstand (58) sind, der sich zwischen der Gleichspannungsquelle (51) und der ersten Schicht (26) befindet, um einen Spannungsabfall gemäß der erfaßten Potentialänderung zu bewirken.

6. Elektronische Schaltung nach Anspruch 5, dadurch gekennzeichnet, daß die Mittel zum Erfassen einer Potentialänderung ein Element (60) enthalten, dessen Ausgangsstrom sich verändern kann entsprechend dem Potential an dem Übergang des Halbleiterelements (10, 62, 64) und der ersten Schicht (26).

7. Elektronische Schaltung nach einem der Ansprüche 1 bis 6, dadurch gekennzeichnet, daß die erste Schicht (26) eine epitaxiale Schicht ist, die in dem Halbleitersubstrat (12) gebildet ist.

8. Elektronische Schaltung nach einem der Ansprüche 1 bis 7, gekennzeichnet durch eine implantierte Schicht (16) zum Isolieren des Halbleiterelements (10, 62, 64) gegenüber dem Halbleitersubstrat (12).

9. Elektronische Schaltung nach einem der Ansprüche 1 bis 8, dadurch gekennzeichnet, daß das Halbleiterelement ein Transistor (10), eine Diode (62) oder ein Kondensator (64) ist.

10. Elektronische Schaltung nach einem der Ansprüche 1 bis 9, dadurch gekennzeichnet, daß das Halbleitersubstrat (12) ein P-Substrat ist, die erste Schicht (26) eine N-Schicht ist, die dritte Schicht (28) eine P-Schicht ist, wobei ein PN-Übergang zwischen einer P-Schicht des Halbleiterelements (10, 62, 64) und der ersten Schicht (26) gebildet ist, und daß die Mittel (50, 51) zum Vorspannen in Sperrrichtung betätigbar sind, um an die erste Schicht (26) ein Potential anzulegen, das niedriger als das an die dritte Schicht (28) gelegte ist.

## Revendications

1. Circuit électronique comprenant:
un élément (10, 62, 64) à semiconducteur autour duquel une jonction PN est formée dans un substrat à semiconducteur ;
un moyen (50) pour une polarisation en sens inverse de la jonction PN autour dudit élément (10, 62, 64) à semiconducteur afin d'isoler ledit élément à semiconducteur des autres éléments ;
et
un moyen (56, 58, 60) pour maintenir en permanence dans un état de coupure une diode parasite (54) qui est apte à être située entre une première couche (26) autour dudit élément (10, 62, 64) à semiconducteur, afin de constituer une jonction PN, et une deuxième couche (18) constituant ledit élément (10) à semiconducteur,
une troisième couche (28) agencée de manière à être connectée à ladite première couche (26) pour former une jonction PN ;
caractérisé par
le fait que ledit moyen (50, 51) pour une polarisation en sens inverse est efficace sur la jonction PN desdits première et troisième couches (26, 28);
un moyen (56, 60) pour détecter une variation de potentiel à la jonction PN entre ledit élément (10, 62, 64) à semiconducteur et ladite première couche (26); et
un moyen (56, 58, 60) pour régler le potentiel de ladite première couche (26) de manière à annuler ladite variation de potentiel détectée ;
ledit moyen (56, 60) pour détecter une variation de potentiel et ledit moyen (56, 58, 60) pour régler le potentiel étant connectés à la diode parasite (54) et pour former ledit moyen (56, 58, 60) de maintien dans un état de coupure pouvant fonctionner pour maintenir une tension, qui est appliquée aux bornes de ladite diode parasite (54), à une valeur constante inférieure à un seuil de ladite diode parasite (54).

2. Circuit électronique selon la revendication 1, caractérisé par un substrat (12) à semiconducteur, ledit élément (10, 62, 64) à semiconducteur étant formé dans ledit substrat (12) à semiconducteur et apte à être isolé des autres éléments formés dans ledit substrat (12) à semiconducteur ; et lesdites première couche (26) et troisième couche (28) étant aussi formées dans ledit substrat (12) à semiconducteur.

3. Circuit électronique selon la revendication 1 ou 2, caractérisé en ce que ledit moyen de polarisation en sens inverse est une source d'alimentation en courant continu (50) connectée à une extrémité de ladite première couche (26), ledit moyen (56) de réglage de potentiel pouvant fonctionner pour augmenter ou réduire le potentiel à l'autre extrémité de ladite source d'alimentation en courant continu (50), avec une augmentation ou une diminution de ladite variation de potentiel détectée.

4. Circuit électronique selon la revendication 3, caractérisé en ce que ledit moyen de détection de variation de potentiel comporte un détecteur (56) de tension ayant un gain de + 1 connecté à la jonction PN dudit élément (10, 62, 64) à semiconducteur avec ladite première couche (26).

5. Circuit électronique selon la revendication 1 ou 2, caractérisé en ce que ledit moyen de polarisation en sens inverse est une source d'alimentation en courant continu (51) connectée entre lesdites première et troisième couches (26, 28), et ledit moyen de réglage de potentiel est une résistance (58) située entre ladite source d'alimentation en courant continu (51) et ladite première couche (26) pour provoquer une chute de tension en fonction de la variation de potentiel détectée.

6. Circuit électronique selon la revendication 5, caractérisé en ce que ledit moyen de détection de variation de potentiel comporte un élément (60) dont le courant de sortie peut varier en fonction du potentiel à la jonction dudit élément (10, 62, 64) à semiconducteur et de ladite première couche (26).

7. Circuit électronique selon l'une quelconque des revendications 1 à 6,
caractérisé en ce que ladite première couche (26) est une couche épitaxiale formée dans ledit substrat (12) à semiconducteur.

8. Circuit électronique selon l'une quelconque des revendications 1 à 7,
caractérisé par une couche implantée (16) pour isoler ledit élément (10, 62, 64) à semiconducteur dudit substrat (12) à semiconducteur.

9. Circuit électronique selon l'une quelconque des revendications 1 à 8,
caractérisé en ce que ledit élément à semiconducteur est un élément quelconque parmi un transistor (10), une diode (62) et un condensateur (64).

10. Circuit électronique selon l'une quelconque des revendications 1 à 9,
caractérisé en ce que ledit substrat (12) à semiconducteur est un substrat P, ladite première couche (26) est une couche N, ladite troisième couche (28) est une couche P, une jonction PN (18) est formée entre une couche P dudit élément (10, 62, 64) à semiconducteur et ladite première couche (26), et ledit moyen (50, 51) de polarisation en sens inverse peut fonctionner pour appliquer à ladite première couche (26) un potentiel inférieur à celui appliqué à ladite troisième couche (28).
